Europäisches Patentamt

European Patent Office

Office européen des brevets

(19)

(11)  EP 1 014 573 B1

(12)  **EUROPEAN PATENT SPECIFICATION**

(45) Date of publication and mention
of the grant of the patent:
**14.07.2004  Bulletin 2004/29**

(51) Int Cl.7: **H03H 11/04**

(21) Application number: **98830760.9**

(22) Date of filing: **17.12.1998**

(54) **Analog equalization low pass filter structure**

Tiefpassfilterstruktur mit analoger Entzerrung

Structure de filtrage passe-bas avec égalisation analogue

(84) Designated Contracting States:
**DE FR GB IT**

(43) Date of publication of application:
**28.06.2000  Bulletin 2000/26**

(73) Proprietor: **STMicroelectronics S.r.l.**
**20041 Agrate Brianza (Milano) (IT)**

(72) Inventors:
• **Bollati, Giacomino**
**29015 Castel San Giovanni (IT)**
• **Alini, Roberto**
**Pleasanton, CA 94588 (US)**
• **Ottini, Daniele**
**27100 Pavia (IT)**

• **Bruccoleri, Melchiorre**
**20017 Rho (IT)**

(74) Representative: **Pellegri, Alberto et al**
**c/o Società Italiana Brevetti S.p.A.**
**Piazza Repubblica, 5**
**21100 Varese (IT)**

(56) References cited:
• **PRODANOV V I ET AL: "BIQUAD GM-C STRUCTURES WHICH USE DOUBLE-OUTPUT TRANSCONDUCTORS" 38TH. MIDWEST SYMPOSIUM ON CIRCUITS AND SYSTEMS: PROCEEDINGS, RIO DE JANEIRO, AUG. 13 - 16, 1995, vol. 1, no. SYMP. 38, 13 August 1995, pages 170-173, XP000684541 CALOBA L P;DINIZ P; DE QUEIROZ A; WATANABE E H (EDS )**

**Description**

FIELD OF THE INVENTION

The present invention relates to an analog equalization structure of amplified signals originating from a transducer and more in particular to a low pass filter architecture with programmable equalization characteristic.

BACKGROUND OF THE INVENTION

In analog or digital data read/acquisition systems by way of transducers, after preamplifying the signal and eventually implementing an automatic gain regulation, it is almost unavoidable to effect an equalization which consists in increasing the gain in the range of the frequency spectrum where the signal generated by a transducer has the maximum energy.

The read channels of data recorded on mass memory devices, such as for example the common HDDs, require similar processings including an analog pre-equalization which increases the read channel gain in the frequency range wherein the signals have the maximum energy.

Historically, the read channels realize this analog pre-equalization operation, or in any case a first part of it, by modifying the frequency response profile of a low pass filter, introducing two real and opposite zeroes in transfer function. In this way, the group-delay parameter (that is the phase delay $d\phi$, where $\phi$ is the phase of transfer function) remains unchanged.

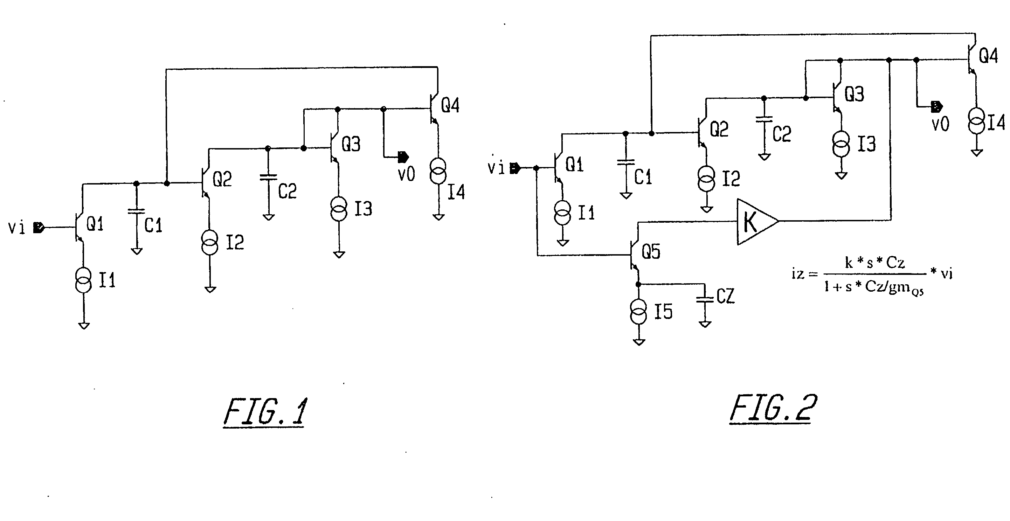

Fig. 1 shows the classical structure of a biquadratic cell (BIQUAD), whose transfer function $vo/vi$, in the domain of the variable $s$ (Laplace transform), is given by:

$$\frac{vo}{vi} = \frac{gm_{Q1}/gm_{Q4}}{1+s*C1*gm_{Q3}/(gm_{Q2}*gm_{Q4})+s^2*C1*C2/(gm_{Q2}*gm_{Q4})}$$

To simplify description, all illustrations are of a single-ended architecture, employing a bipolar transconductor device. However, as it will be evident to any skilled person, all circuits shown and described according to a single-ended embodiment may be realized also in a fully differential embodiment and may employ a transconductor of any type, for example made in CMOS technology instead of in a bipolar junction technology.

Such biquadratic cell structures, including a low pass structure, are knwon e.g. from Prodanow VI. et al: "Biquad GmC Structures which Use Double-Output Transconductors", Proceedings of 38th Midwest Symposium on Circuits and Systems, Rio de Janeiro, Aug. 13 - 16, 1995, vol. 1, no. SYMP. 38, pages 170-173.

As highlighted in the scheme of Fig. 1, the two programmable real and opposed zeroes programmable are implemented by injecting on the output node of the circuit of Fig. 1, a current given by:

$$iz = k*s*Cz*Vi$$

where k is the current gain of the buffer stage of the injection current $iz$, such to obtain the classical circuit used in the read channels, shown in Fig. 2.

As well known to the skilled technician, the problem with the known circuit of Fig. 2 is to assure that the parasite pole $gm_{Q5}/Cz$ remains securely positioned to a frequency higher than that of the other poles of the transfer function, in order to obtain a transfer function which, in first approximation (that is by neglecting the parasite pole $gm_{Q5}/Cz$ if sufficiently far from the filter's band), is given by:

$$\frac{vo}{vi} = \frac{gm_{Q1}/gm_{Q4} - s^2*C3/C2*C1*C2/(gm_{Q2}*gm_{Q4})}{1+s*C1*gm_{Q3}/(gm_{Q2}*gm_{Q4})+s^2*C1*C2/(gm_{Q2}*gm_{Q4})}$$

This requirement implies a nonnegligible power consumption for ensuring the above indicated condition. For the known circuit of Fig. 2 this condition may be expressed by the following disequality:

$$gm_{Q5}/Cz >> sqrt(gm_{Q2}*gm_{Q4}/(C1*C2)$$

On the other hand, for noise immunity and matching reasons, $Cz$ must be approximately equal to C1 and C2 and therefore $gm_{Q5}$ must be much greater than $gm_{Q2}$ and $gm_{Q4}$.

By considering that the power absorbed is directly proportional to the transconductance *gm* of the stage, the commonly used equalization circuits, as illustrated in Fig. 2, imply a high power dissipation.

OBJECT AND SUMMARY OF THE INVENTION

Vis-à-vis this state of the art, it has now been found a way to avoid such a power dissipation for keeping the parasitic poles of the transfer function of the circuit that generates two programmable real and opposed zeroes, at a frequency sufficiently higher than the frequency spectrum of the transducer signal.

This important result is obtained, according to the present invention, as defined by the appended claims by realizing a low pass filter with a programmable equalization whose transfer function has two distinct and real poles, formed by two structurally similar circuits and functionally connected in cascade one to the other, each circuit being composed by a biquadratic cell and by an input stage having two outputs: a current output and a voltage output.

In order to introduce two real and opposed zeroes in the filter's transfer function, in each of the two circuits in cascade, the current output of the input stage is coupled to the node of the input capacitor of the respective biquadratic cell, directly in the first circuit and in an inverted manner in the second circuit; the voltage output of the input stage being coupled to the input of the respective biquadratic cell.

In case of a single-ended low pass filter, the inversion of the current proportional to the derivative of the relative input voltage may be done by a current inverting stage, whereas, in case of a fully differential low pass filter the necessary inversion of the injected current may be simply realized by crossing the relative connections, without the need of a current inverting stage.

BRIEF DESCRIPTION OF THE DRAWINGS

The various aspects and advantages of the invention will become even clearer through the following description of an embodiment and by referring to the attached drawings, wherein:

> **Figure 1** shows the classical circuit diagram of a biquadratic cell;
> **Figure 2** shows the circuit diagram of a low pass filter with programmable equalization;
> **Figure 3** is a circuit diagram of a low pass filter with programmable equalization, according to the present invention.

DESCRIPTION OF AN EMBODIMENT OF THE INVENTION

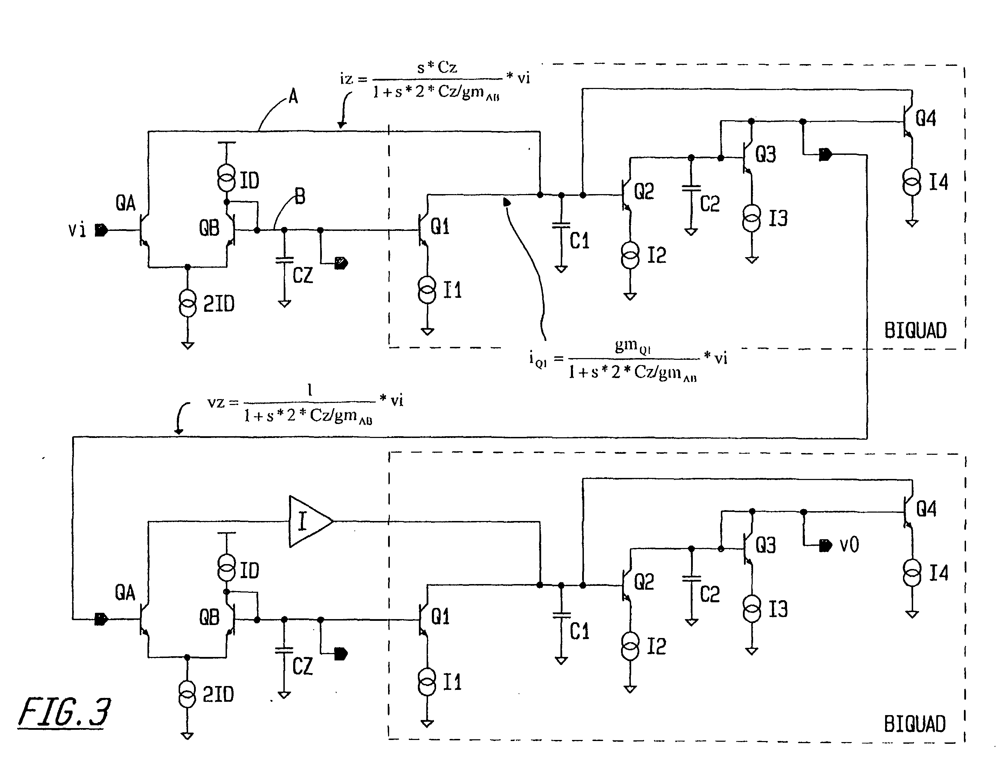

With reference to Fig. 3, which for simplicity's sake shows an embodiment of a low pass filter with programmable equalization according to the present invention, having a single ended configuration, the low pass filter of programmable equalization of the invention is composed of two structurally similar circuits, functionally connected in cascade, whose transfer function in the domain of the Laplace transform is given by:

$$\frac{vo}{vi} = \frac{s*Cz+gm_{Q1}}{1+s*2*Cz/gm_{AB}} * \frac{1/gm_{Q4}}{1+s*C1*gm_{Q3}/(gm_{Q2}*gm_{Q4})+s\char`\^2*C1*C2/(gm_{Q2}*gm_{Q4})}$$

Each circuit comprises a common biquadratic cell (BIQUAD) and a fully differential input stage having two outputs: A and B, respectively, the first being a current output and the second being a voltage output.

The current output A of the input stage is coupled to the node of the input capacitor C1 of the respective biquadratic cell BIQUAD, such to inject a current proportional to the derivative of the voltage present at the stage input. As highlighted in Fig. 3, the injection of this current in the respective biquadratic cell for introducing two real and opposed zeroes in the filter's transfer function, takes place by direct coupling in the first circuit, while in the second circuit such a current is preventively inverted by a common current inverter I.

Of course, should a fully differential low pass filter be required, it will be sufficient to "duplicate" the structure of Fig. 3 for both the differential output branches. In this case the required inversion of the current injected in the relative biquadratic cell to introduce two real and opposed zeroes in the transfer function, may be readily done by crossing the relative connections between the two branches of the differential output circuit.

The second voltage output B of the input stage is coupled to the input of the respective biquadratic cell BIQUAD.

The two circuits are substantially identical though there exists an inverting stage I of the current injected in the biquadratic cell of the second circuit.

Each input stage is composed by the pair of NPN transistors, QA and QB, by the bias generator 2IO and by the load generator IO of the voltage output branch.

By considering the case:

$$gm_A = gm_B = gm_{AB}$$

each input stage through the output current A delivers a current given by:

$$iz = s*Cz/(1+s*2*Cz/gm_{AB})*vi$$

where *vi* represents the signal present at the input of the stage, that is on the base of the transistor QA of the input stage, while the output voltage on the node B coupled to the input of the respective biquadratic cell is given by:

$$vz = 1/(1+s*2*Cz/gm_{AB})*vi$$

where also in this case vi represents the signal present at the input of the stage.

The filter's boost may be programmed by modifying the zeroes position, as in the known circuit of Fig. 2.

**Claims**

1. A low pass filter with programmable equalization comprising at least a biquadratic cell (BIQUAD) and a converter of the input voltage (Vin) into a current (*iz*) proportional to the derivative of the input voltage (Vin), current that is injected on a node of the biquadratic cell (BIQUAD) in order to introduce two real and opposed zeroes in the transfer function of the filter, **characterized in that** the filter comprises two structurally similar circuits, functionally connected in cascade, each circuit being composed of a biquadratic cell and a converter of the input voltage into a current proportioned to the derivate of the input voltage having two outputs injecting through a first current output (A) said current (*iz*) on an input capacitor (C1) of the respective biquadratic cell, by a direct coupling in a first of said two circuits and in an inverted manner in the second of said two circuits;
   a second voltage output (B) being coupled to an input of the respective biquadratic cell.

2. The low pass filter according to claim 1, **characterized in that** is a single-ended filter and in the second of said two structurally similar circuits in cascade, said current (*iz*) is preventively inverted by a current inverter (I).

3. The low pass filter according to claim 1, **characterized in that** is a differential output filter comprising two of said pairs of said structurally similar circuits connected in cascade, and wherein the inversion of said current (*iz*) injected in the biquadratic cell of the second circuit of the two pairs is realized by crossing the relative connections.

**Patentansprüche**

1. Tiefpassfilter mit programmierbarer Entzerrung, mit wenigstens einer biquadratischen Zelle (BIQUAD) und einem Umsetzer, der die Eingangsspannung (Vin) in einen zu der Ableitung der Eingangsspannung (Vin) proportionalen Strom (iz) umsetzt, der in einen Knoten der biquadratischen Zelle (BIQUAD) eingeleitet wird, um in die Übertragungsfunktion des Filters zwei reelle und entgegengesetzte Nullstellen einzuführen, **dadurch gekennzeichnet, dass** das Filter zwei strukturell ähnliche Schaltungen umfasst, die funktional in Kaskade geschaltet sind, wobei jede Schaltung aus einer biquadratischen Zelle und aus einem Umsetzer aufgebaut ist, der die Eingangsspannung in einen zu der Ableitung der Eingangsspannung proportionalen Strom umsetzt und zwei Ausgänge besitzt, um über einen ersten Stromausgang (A) den Strom (iz) in einen Eingangskondensator (C1) der entsprechenden biquadratischen Zelle durch eine direkte Kopplung in einer ersten der zwei Schaltungen und eine invertierte Kopplung in der zweiten der zwei Schaltungen einzuleiten;
   wobei ein zweiter Spannungsausgang (B) mit einem Eingang der entsprechenden biquadratischen Zelle gekoppelt ist.

2. Tiefpassfilter nach Anspruch 1, **dadurch gekennzeichnet, dass** es ein Eintaktfilter ist und in der zweiten der zwei in Kaskade geschalteten strukturell ähnlichen Schaltungen der Strom (iz) durch einen Strominverter (I) im Voraus invertiert wird.

**3.** Tiefpassfilter nach Anspruch 1, **dadurch gekennzeichnet, dass** es ein Filter mit differentiellem Ausgang ist, das zwei Paare der in Kaskade geschalteten strukturell ähnlichen Schaltungen umfasst, wobei die Umkehrung des in die biquadratische Zelle der zweiten Schaltung der zwei Paare eingeleiteten Stroms (iz) durch Kreuzen der relativen Verbindungen verwirklicht wird.

**Revendications**

**1.** Filtre passe-bas à égalisation programmable comprenant au moins une cellule biquadratique (BIQUAD) et un convertisseur de tension d'entrée (Vin) en un courant (iz) proportionnel à la dérivée de la tension d'entrée (Vin), courant qui est injecté sur un noeud de la cellule biquadratique (BIQUAD) de façon à introduire deux zéros réels et opposés dans la fonction de transfert du filtre, **caractérisé en ce que** le filtre comprend deux circuits structurellement similaires, fonctionnellement connectés en cascade, chaque circuit étant composé d'une cellule biquadratique et d'un convertisseur de tension d'entrée en un courant proportionnel à la dérivée de la tension d'entrée, ayant deux sorties injectant par une première sortie (A) ledit courant (iz) sur le condensateur d'entrée (C1) de la cellule biquadratique respective, par un couplage direct dans un premier des deux circuits et de façon inversée dans le second des deux circuits ;
une seconde sortie de tension (B) couplée à une entrée de la cellule biquadratique respective.

**2.** Filtre passe-bas selon la revendication 1, **caractérisé en ce qu'**il constitue un filtre à une seule sortie et **en ce que**, dans le second des deux circuits structurellement similaires en cascade, le courant (iz) est inversé à l'avance par un inverseur de courant (I).

**3.** Filtre passe-bas selon la revendication 1, **caractérisé en ce qu'**il constitue un filtre à sortie différentielle comprenant deux desdites paires de circuits structurellement similaires connectées en cascade, et dans lequel l'inversion du courant (iz) injecté dans la cellule biquadratique du second circuit des deux paires est réalisée en croisant les connexions correspondantes.

_FIG.1_

$$iz = \frac{k * s * Cz}{1 + s * Cz/gm_{Q5}} * vj$$

_FIG.2_

EP 1 014 573 B1

FIG.3

$$iz = \frac{s * Cz}{1 + s * 2 * Cz/gm_{AB}} * vi$$

$$i_{Q1} = \frac{gm_{Q1}}{1 + s * 2 * Cz/gm_{AB}} * vi$$

$$vz = \frac{1}{1 + s * 2 * Cz/gm_{AB}} * vi$$

EP 1 014 573 B1